(19) Europäisches Patentamt / European Patent Office / Office européen des brevets

(11) **EP 1 840 149 A1**

(12) **EUROPEAN PATENT APPLICATION**
published in accordance with Art. 158(3) EPC


(43) Date of publication:
**03.10.2007 Bulletin 2007/40**

(21) Application number: **06702621.1**

(22) Date of filing: **13.01.2006**

(51) Int Cl.:
***C08G 59/24*** *(2006.01)* ***H01L 21/312*** *(2006.01)*
***H05K 3/46*** *(2006.01)*

(86) International application number:
**PCT/JP2006/300333**

(87) International publication number:
**WO 2006/077771 (27.07.2006 Gazette 2006/30)**

(84) Designated Contracting States:
**CH DE FR GB LI**

(30) Priority: **19.01.2005 JP 2005011709**



(71) Applicant: **DAICEL CHEMICAL INDUSTRIES, LTD.**
**Sakai-shi, Osaka 590-8501 (JP)**

(72) Inventor: **SATO, Atsushi**
**Yamaguchi, 7400018 (JP)**

(74) Representative: **Grünecker, Kinkeldey,**
**Stockmair & Schwanhäusser**
**Anwaltssozietät**
**Maximilianstrasse 58**
**80538 München (DE)**


(54) **CURABLE RESIN COMPOSITION AND INTERLAYER INSULATING FILM**


(57) A curable resin composition includes a cycloaliphatic epoxy compound of following Formula (1):

[Chemical Formula 1]

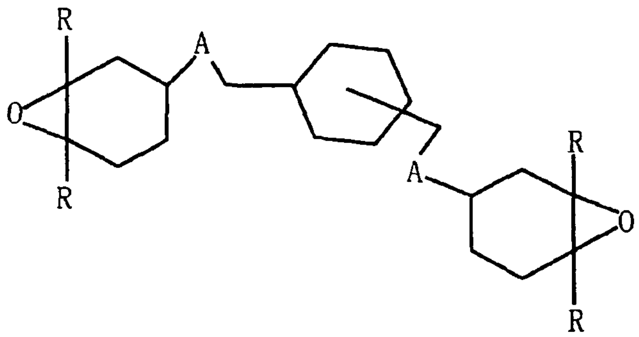

(1)

wherein R represents hydrogen atom or a hydrocarbon group having one to five carbon atoms; and A represents a group selected from ether group, thioether group, sulfonyl group, carbonyl group, carbonate group, ester group, and acetal group; and a cationic polymerization initiator or a curing agent. The cationic polymerization initiator can be a heat-induced cationic polymerization initiator or a photo-induced cationic polymerization initiator. The curing agent can be a polybasic acid anhydride.


EP 1 840 149 A1

## Description

### Technical Field

The present invention relates to curable resin compositions and interlayer dielectric films as cured products of the compositions, which are excellent heat resistance, adhesion, and flexibility and can be used typically in LSIs and multilayer printed wiring boards.

### Background Art

Interlayer dielectric films used in LSIs and multilayer printed wiring boards have been conventionally formed by physical vapor deposition (PVD) such as vacuum evaporation or sputtering of inorganic materials. However, such methods for forming dielectric films by PVD cannot significantly yield multilayer dielectric films, thereby have insufficient productivity and invite high cost. In contrast, interlayer dielectric films using polyimide resins as organic materials have been developed. The polyimide-based films, however, undergo reduction in film thickness and subsequent reduction in surface smoothness and have poor adhesion with base materials and other components (Japanese Unexamined Patent Application Publication (JP-A) No. 01-278561). As a possible solution to these problems, an interlayer dielectric film using a thermosetting resin mainly containing a cycloaliphatic epoxy resin (compound) has been proposed (JP-A No. 06-85091). The interlayer dielectric film using the thermosetting resin has good surface smoothness and excellent heat resistance but still has insufficient adhesion with base materials, particularly with plated metal layers for conductor circuitry, and does not have sufficiently improved reliability.

Patent Document 1: Japanese Unexamined Patent Application Publication (JP-A) No. 01-278561
Patent Document 1: Japanese Unexamined Patent Application Publication (JP-A) No. 06-85091

### Disclosure of Invention

### Problems to be solved by the Invention

Accordingly, an object of the present invention is to provide interlayer dielectric films which show less shrinkage on curing, are excellent in adhesion with base materials, heat resistance, and flexibility, and show high reliability.

Means for Solving the Problems

After intensive investigations to achieve the above objects, the present inventors have found that cured products of cycloaliphatic epoxy compounds having specific structures show less shrinkage on curing, are excellent in heat resistance and flexibility and can satisfactorily adhere to plated metal layers. The present invention has been achieved based on these findings.

Specifically, the present invention provides, in a first aspect, a curable resin composition containing at least one cycloaliphatic epoxy compound represented by following Formula (1) :

[Chemical Formula 1]

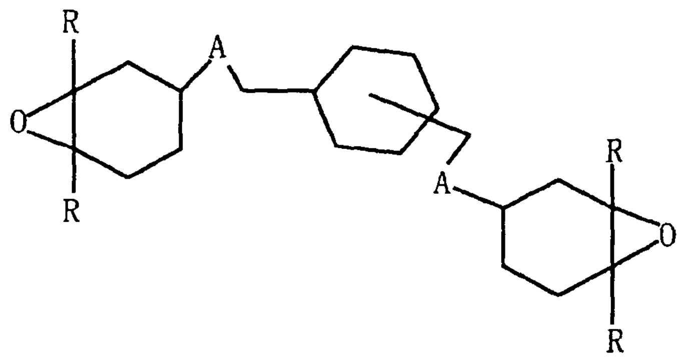

(1)

wherein R represents hydrogen atom or a hydrocarbon group having one to five carbon atoms; and A represents a group selected from the group consisting of ether group, thioether group, sulfonyl group, carbonyl group, carbonate group, ester group, and acetal group; and at least one of a cationic polymerization initiator or a curing agent.
The present invention provides, in a second aspect, a curable resin composition according to the first aspect in which the cationic polymerization initiator can be a heat-induced cationic polymerization initiator.
The present invention provides, in a third aspect, a curable resin composition according to the first aspect in which the cationic polymerization initiator can be a photo-induced cationic polymerization initiator.
The present invention provides, in a fourth aspect, a curable resin composition according to the first aspect in which the curing agent can be a polybasic acid anhydride.
The present invention provides, in a fifth aspect, a curable resin composition according to any one of first , second , third and fourth aspects in which the polar group A is preferably an ester group.
The present invention provides, in a sixth aspect, an interlayer dielectric film as a cured product of the curable resin composition according to any one of first , second , third , fourth and fifth aspects.

Advantages

The curable resin compositions according to the present invention yield interlayer dielectric films that show less shrinkage on curing and are excellent in heat resistance, flexibility, and adhesion with plated metal layers.

Description of the Preferred Embodiments

The present invention will be illustrated in detail below.
Cycloaliphatic epoxy compounds represented by Formula (1) for use in the present invention structurally have three alicyclic skeletons connected with the interposition of a polar group A. The polar group A can be a group selected from ether group, thioether group, sulfonyl group, carbonyl group, carbonate group, ester group, and acetal group.
Examples of the cycloaliphatic epoxy compounds represented by Formula (1) are epoxy compounds as epoxidized products of 1,4-bis(3-cyclohexenyl)cyclohexylmethyl ether with an epoxidizing agent such as peracetic acid; epoxy compounds as epoxidized products of 1,4-bis(3-cyclohexenyl)cyclohexylmethyl ketone with an epoxidizing agent; and epoxy compounds as epoxidized products of 1,4-bis(3-cyclohexenylcarboxymethyl)cyclohexane with an epoxidizing agent. Among them, epoxy compounds as epoxidized products of 1,4-bis(3-cyclohexenylcarboxymethyl)cyclohexane with epoxidizing agent are preferred.
Typical examples of the cycloaliphatic epoxy compounds represented by Formula (1) are represented by following Formulae.

[Chemical Formula 2]

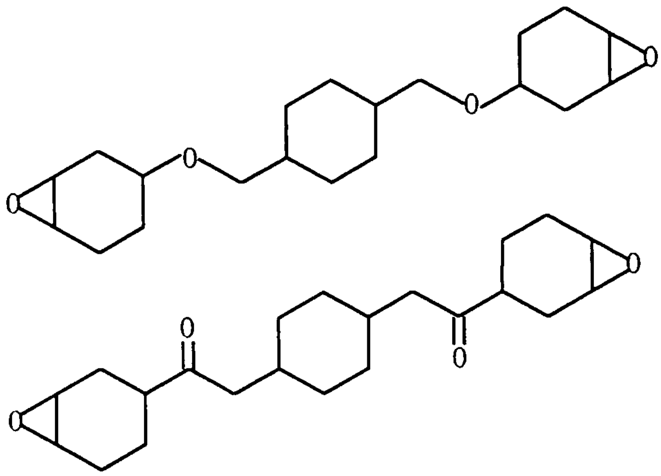

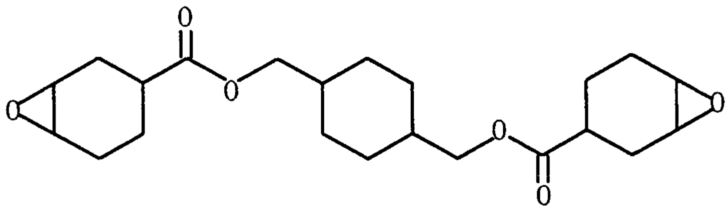

Methods for preparing the cycloaliphatic epoxy compounds represented by Formula (1) are described, for example, in JP-A No. 05-170753 and Japanese Patent Application No. 2004-236505, of which one described in the latter document is preferred.

JP-A No. 05-170753 discloses a process for producing an epoxy compound using an ester interchange method wherein a lower alkyl ester of cycloaliphatic epoxide is allowed to react with a suitable active hydorogen compound in the presence of a metal salt of a weak acid or a mixture there of as a catalyst. On the other hand, Japanese Patent Application No. 2004-236505 discloses a process for producing an epoxy compound wherein 3-cyclohexenylmethyl-3-cyclohexenecarboxylate is allowed to react with 2 to 6-functional compound having alcoholic hydroxy groups using an ester interchange method to yield a cycloaliphatic olefinic polyvalent ester compound and then the cycloaliphatic olefinic polyvalent ester compound is epoxidated with a peracid or hydrogen peroxide.

Among them, cycloaliphatic epoxy compounds represented by Formula (1) epoxidized cycloaliphatic olefinic polyvalent ester compound with substantially anhydrous peracetic acid are preferred, since they have high epoxidation rates and yield interlayer dielectric films that are excellent in properties such as adhesion with base materials. Such anhydrous peracetic acid preferably has a water content of less than 0.8 percent by weight.

Cationic polymerization initiators for use in the curable resin compositions according to the present invention include photo-induced cationic polymerization initiators and heat-induced cationic polymerization initiators. The photo-induced cationic polymerization initiators are compounds that form cation species by the action of active energy rays to thereby initiate cationic polymerization of epoxy compounds. Examples thereof are cationic polymerization initiators such as iodonium salts and sulfonium salts represented by following Formulae (2) to (8):

Formula (2):

[Chemical Formula 3]

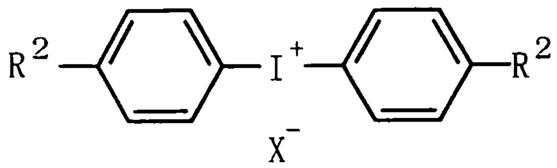

(2)

wherein $R^2$ represents an alkyl group having one to fifteen carbon atoms or an alkoxy group having one to fifteen carbon atoms; and $X^-$ represents $PF_6^-$, $SbF_6^-$, or $AsF_6^-$,

Formula (3)

[Chemical Formula 4]

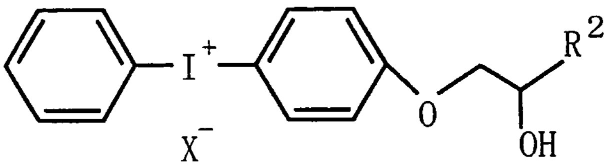

(3)

wherein $R^2$ represents an alkyl group having one to fifteen carbon atoms or an alkoxy group having one to fifteen carbon atoms; and $X^-$ is as defined above,

Formula (4)

[Chemical Formula 5]

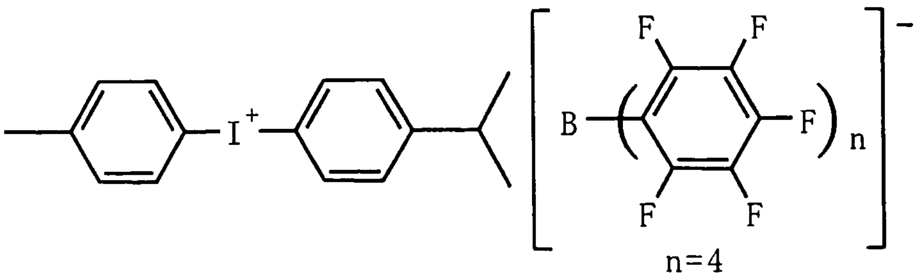

(4)

Formula (5)

[Chemical Formula 6]

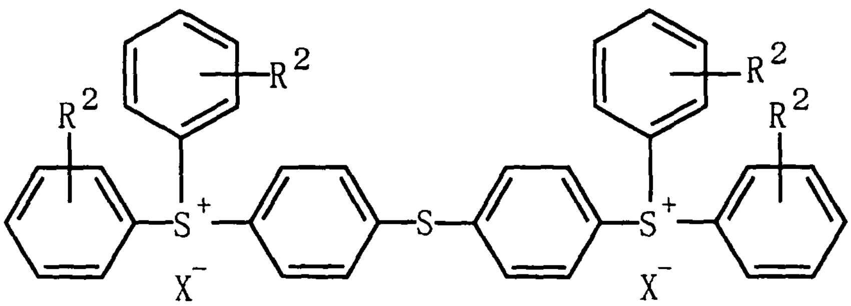

(5)

wherein $R^2$ represents an alkyl group having one to fifteen carbon atoms or an alkoxy group having one to fifteen carbon atoms; and $X^-$ is as defined above,

Formula (6)

[Chemical Formula 7]

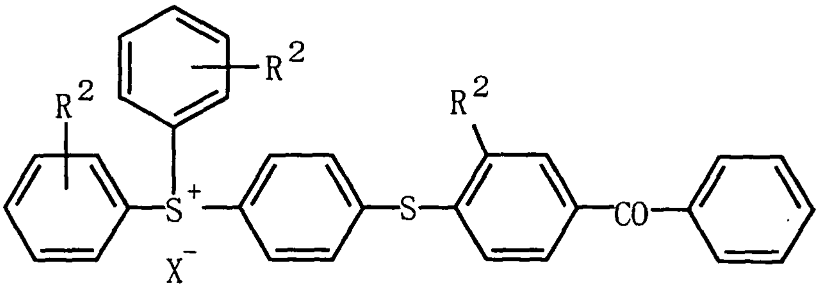

(6)

wherein $R^2$ represents an alkyl group having one to fifteen carbon atoms or an alkoxy group having one to fifteen carbon atoms; and $X^-$ is as defined above,

Formula (7)

[Chemical Formula 8]

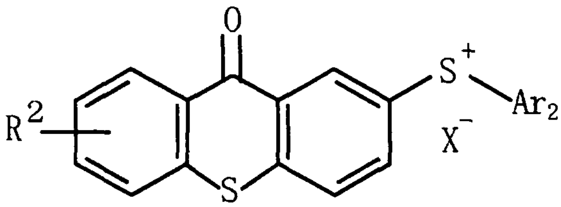

(7)

wherein $R^2$ represents an alkyl group having one to fifteen carbon atoms or an alkoxy group having one to fifteen carbon atoms; Ar represents an aryl group such as phenyl group; and $X^-$ is as defined above, and

Formula (8)

[Chemical Formula 9]

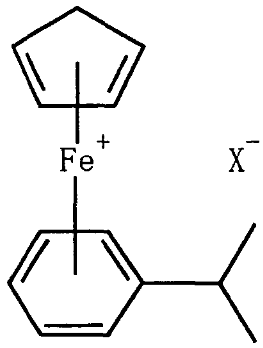

(8)

wherein $X^-$ is as defined above.

The heat-induced cationic polymerization initiators for use in the curable resin compositions according to the present invention are compounds that form cation species as a result of heating to thereby initiate cationic polymerization of epoxy compounds. Examples thereof are cationic polymerization initiators such as hexafluoroantimonate salts, pentafluorohydroxyantimonate salts, hexafluorophosphate salts, and hexafluoroarsenate salts represented by following Formulae (9) to (17):

Formula (9)

[Chemical Formula 10]

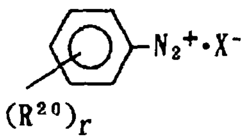

(9)

wherein $R^{20}$ represents an alkyl group having one to twelve carbon atoms or an alkoxy group having one to twelve carbon atoms; r represents an integer of 0 to 3; and $X^-$ is as defined above,

Formula (10)

[Chemical Formula 11]

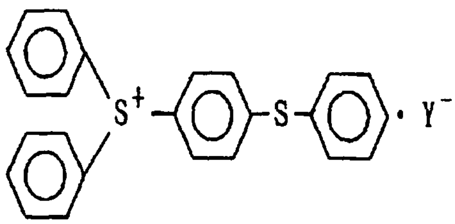

(10)

wherein $Y^-$ represents $PF_6^-$, $SbF_6^-$, $AsF_6^-$, or $SbF_5(OH)^-$ ,

Formula (11)

[Chemical Formula 12]

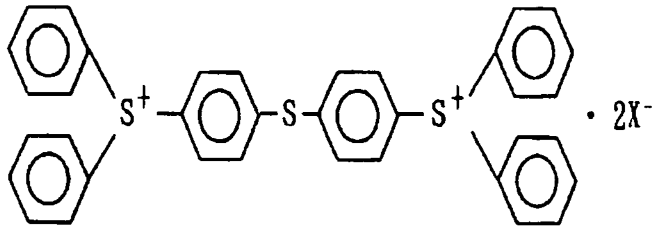

(11)

wherein $X^-$ is as defined above,

Formula (12)

[Chemical Formula 13]

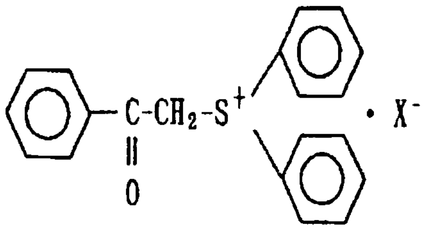

(12)

wherein $X^-$ is as defined above,

Formula (13)

[Chemical Formula 14]

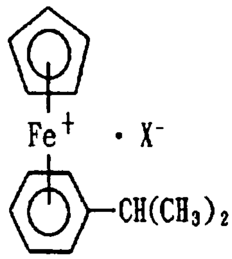

(13)

wherein $X^-$ is as defined above,

Formula (14)

[Chemical Formula 15]

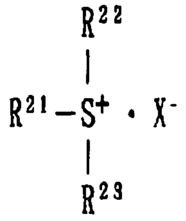

(14)

wherein $R^{21}$ represents an aralkyl group having seven to fifteen carbon atoms or an alkenyl group having three to nine carbon atoms; $R^{22}$ represents hydrocarbon group having one to seven carbon atoms or hydroxyphenyl group; $R^{23}$ represents an alkyl group having one to five carbon atoms and optionally having oxygen atom or sulfur atom; and $X^-$ is as defined above,

Formula (15)

[Chemical Formula 16]

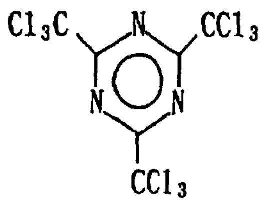

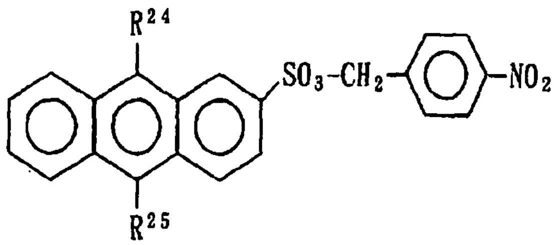

(15)

wherein each of $R^{24}$ and $R^{25}$ independently represents an alkyl group having one to twelve carbon atoms or an alkoxy group having one to twelve carbon atoms,

Formula (16)

[Chemical Formula 17]

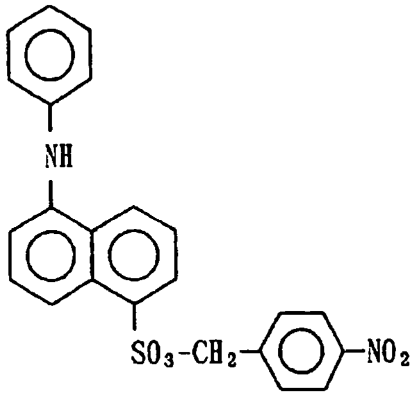

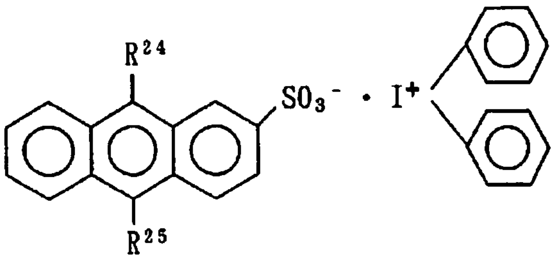

(16)

wherein $R^{24}$ and $R^{25}$ are as defined above.

Formula (17)

[Chemical Formula 18]

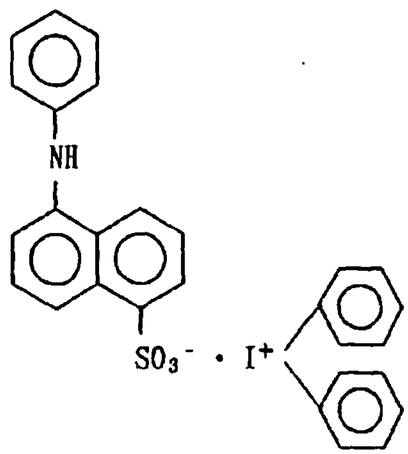

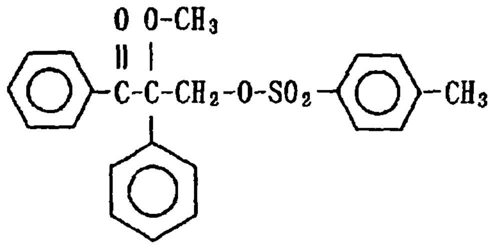

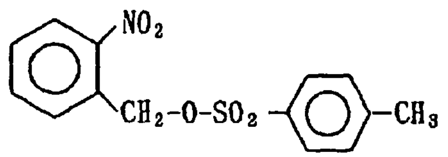

(17)

Commercially available heat-induced cationic polymerization initiators can also be used. They can be obtained, for example, under the trade names of SI-100L and SI-60L from Sanshin Chemical Industry Co., Ltd.; and CP-66 from Asahi Electric Industry Co., Ltd.
Instead of using these onium salt heat-induced cationic polymerization catalysts, the cationic polymerization can also be carried out using a chelate compound between aluminum or titanium and a β-diketone or a β-ketoester in combination with a silanol-containing compound or bisphenol-S.
Examples of the β-diketone or a β-ketoester to coordinate with aluminum or titanium are acetylacetone and acetoacetic acid esters. These chelate compounds are commercially available, for example, under the trade names of ALCH-TR from Kawaken Fine Chemicals Co., Ltd.; and DAICAT EX-1 from Daicel Chemical Industries, Ltd.
Each of heat-induced cationic polymerization initiators and photo-induced cationic polymerization initiators can be used alone or in combination, respectively. One or more kind of heat-induced cationic polymerization initiator and one or more kind of photo-induced cationic polymerization initiator can be used in combination.
Curing agents for use in the curable resin compositions according to the present invention can be any curing agents that react with epoxy group upon heating, but amine curing agents are not preferred since they show poor heat resistance after curing. Curing agents showing good heat resistance after curing include polybasic acid anhydrides such as phthalic anhydride, trimellitic anhydride, pyromellitic anhydride, benzophenonetetracarboxylic acid anhydride, $\Delta^4$-tetrahydrophthalic anhydride, 4-methyl-$\Delta^4$-tetrahydrophthalic anhydride, 3-methyl-$\Delta^4$-tetrahydrophthalic anhydride, nadic anhydride, methylnadic anhydride, hydrogenated methylnadic anhydride, 4-(4-methyl-3-pentenyl)tetrahydrophthalic anhydride, succinic anhydride, adipic anhydride, maleic anhydride, sebacic anhydride, dodecanedioic anhydride, methylcyclohexenetetracarboxylic anhydride, dodecenylsuccinic anhydride, hexahydrophthalic anhydride, 4-methylhexahydrophthalic anhydride, 3-methylhexahydrophthalic anhydride, vinyl ether-maleic anhydride copolymers, and alkylstyrene-maleic anhydride copolymers. The curing agents also include phenolic resins such as phenol novolac resins and cresol novolac resins; imidazole curing agents such as 2-methylimidazole, 2-ethyl-4-methylimidazole, 2-undecylimidazole, 2-heptadecylimidazole, 2-phenylimidazole, 1-benzyl-2-methylimidazole, 1-cyanoethyl-2-methylimidazole, 1-cyanoethyl-2-ethyl-4-methylimidazole, 1-cyanoethyl-2-undecylimidazole, 1-cyanoethyl-2-undecylimidazolium trimellitate, 1-cyanoethyl-2-phenylimidazolium trimellitate, 2-methylimidazolium isocyanurate, 2-phenylimidazolium isocyanurate, 2,4-diamino-6-[2-methylimidazolyl-(1)]-ethyl-s-triazine, and 2,4-diamino-6-[2-ethyl-4-methylimidazolyl-(1)]-ethyl-s-triaz ine; Lewis acid-amine complex curing agents such as $BF_3$-n-hexylamine, $BF_3$-monoethylamine, $BF_3$-benzylamine, $BF_3$-diethylamine, $BF_3$-piperidine, $BF_3$-triethylamine, $BF_3$-aniline, $BF_4$-n-hexylamine, $BF_4$-monoethylamine, $BF_4$-benzylamine, $BF_4$-diethylamine, $BF_4$-piperidine, $BF_4$-triethylamine, $BF_4$-aniline, $PF_5$-ethylamine, $PF_5$-isopropylamine, $PF_5$-butylamine, $PF_5$-laurylamine, $PF_5$-benzylamine, and $AsF_5$-laurylamine; dicyandiamide and derivatives thereof; organic acid hydrazides; diaminomaleonitrile and derivatives thereof; and amine imides. Each of these curing agents can be used alone or in combination.

Examples of curing accelerators are tertiary amines such as benzyldimethylamine and dimethylcyclohexylamine; imidazoles such as 2-ethyl-4-methylimidazole; phosphines such as triphenylphosphine and tris(dimethoxy)phosphine; metal chelates such as aluminum acetylacetone complex; phosphonium salts such as tetramethylphosphonium bromide and tetra-n-butylphosphonium bromide; quaternary ammonium salts such as tetraethylammonium bromide and tetrabutylammonium bromide; metal salts of organic acids, such as tin octanoate, zinc octanoate, and zinc stearate; diazabicycloalkene organic acid salts such as 1, 8-diaza-bicyclo [5.4.0] undecene-7 octanoate salt; and boron compounds such as boron trifluoride and tetraphenylphosphonium tetraphenylborate. Each of these curing accelerators can be used alone or in combination.

Where necessary, the curable resin compositions can further comprise other epoxy compounds, plasticizers, leveling agents, antifoaming agents, ultraviolet absorbers, flame retardants, antioxidants, silane coupling agents, pigments, organic fillers such as polyimide resins, and inorganic fillers such as silica, talc, alumina, clay, and titanium oxide, within ranges not adversely affecting the advantages of the present invention. However, fillers that act to reduce insulation resistance are not desirable when the cured products are used as interlayer dielectric films.

The amount of the photo-induced cationic polymerization initiator is within the range of about 0.1 to about 20 parts by weight, preferably about 0.5 to about 15 parts by weight, and more preferably about 1 to about 10 parts by weight, to 100 parts by weight of the cycloaliphatic epoxy compound represented by Formula (1).
The amount of the heat-induced cationic polymerization initiator is within the range of about 0.01 to about 20 parts by weight, preferably about 0.1 to about 10 parts by weight, and more preferably about 0.5 to about 5 parts by weight, to 100 parts by weight of the cycloaliphatic epoxy compound of Formula (I).
The amount of the curing agent is within the range of about 0.7 to about 1.3 equivalents, preferably about 0.8 to about 1.2 equivalents, and more preferably about 0.9 to about 1.1 equivalents, to 1 equivalent of epoxy group of the cycloaliphatic epoxy compound of Formula (I) or to 1 equivalent of total of epoxy groups of the cycloaliphatic epoxy compound of Formula (I) and other epoxy compounds, if used.
The amount of the curing accelerator is within the range of about 0.1 to about 10 parts by weight, preferably about 0.2 to about 5 parts by weight, and more preferably about 0.3 to about 3 parts by weight, to 100 parts by weight of the curing agent.
If the amounts of the photo-induced or heat-induced cationic polymerization initiator, the curing agent, and the curing accelerator are less than the lower limits of the above-specified ranges, the curing may be insufficient or take a long time. In contrast, if they exceeds the upper limits, the resulting cured products may have poor physical properties.

The curable resin compositions according to the present invention can be prepared by admixing the above-mentioned components with stirring to yield homogenous resin compositions. They can be prepared, for example, by admixing the components, heating them for example at about 40°C according to necessity, and stirring them with a stirrer such as dissolver typically for about twenty minutes to yield a homogenous mixture.

The curable resin compositions according to the present invention can be applied to substrates or wiring boards, for example, by roll coating, spray coating, blush coating, bar coat coating, roller coating, silk screen printing, or spin coating. When the compositions comprise solvents, the solvents are removed from applied films typically by heating, and then the resins are cured by the application of light or heat.

The irradiation conditions of active energy rays such as ultraviolet rays in photo-induced cationic curing using a photo-induced cationic polymerization initiator can be appropriately set depending on the type and thickness of the applied resin composition. The wavelength of ultraviolet rays to be applied is generally preferably within the range of about 200 to about 600 nm. A suitable irradiation source having such wavelengths that the photo-induced cationic polymerization initiator has high sensitivity can be appropriately selected according to the type of the photo-induced cationic polymerization initiator.

The irradiation source for ultraviolet rays includes high-pressure mercury lamps, ultrahigh-pressure mercury lamps, xenon lamps, carbon arc, metal halide lamps, and solar rays. The amount of irradiance is generally preferably within such a range that the dose is within the range of about 10 to about 5,000 $mJ/cm^2$, and particularly preferably 50 to about 2,000 $mJ/cm^2$. Instead of ultraviolet rays, electron beams can also be used as the active energy rays.

The compositions can be heated according to necessity after the application of active energy rays. The heating can reduce unreacted components in the resins and mitigate hardening of applied films induced by application of active energy rays and warping of applied films induced by molding. The heating may also increase the hardness and/or

adhesion of resins. The heating can be generally conducted at an atmosphere temperature of about 100°C to about 200°C for about one minute to about one hundred and twenty minutes.

Heat-induced cationic curing using the heat-induced cationic polymerization initiator and heat curing using the curing agent can be carried out at temperatures of about 40°C to about 250°C, and preferably about 45°C to about 220°C for about thirty minutes to about twelve hours. The heating can be conducted not only at a constant temperature but also at two steps or three steps varying temperature or gradually elevating temperature.

By applying the curable resin compositions to, for example, LSIs and multilayer printed wiring boards and curing the resins by the application of active energy rays or heat, the resulting cured products can be used as interlayer dielectric films.

Examples

The present invention will be illustrated in further detail with reference to several examples below which by no means limit the scope of the present invention. All "parts" and "percentages" are by weight.

The properties as interlayer dielectric films were determined by the following methods.

<Glass transition temperature Tg>

The glass transition temperature was measured using a differentiation scanning calorimeter (DSC) available from Seiko Instruments Inc.

<Shrinkage percentage on curing>

The specific gravity "a" of a sample curable resin composition was measured using a pycnometer, and the specific gravity "b" of a cured product thereof was measured by the underwater replacing method. The shrinkage percentage on curing was determined by calculation according to the following equation.

$$\text{Shrinkage percentage on curing (\%)} = [1-(b/a)] \times 100$$

<Adhesive strength between insulating layer and plated layer>

A sample curable resin composition was applied to a thickness of about 30 μm to a degreased, copper-clad surface of a copper-clad glass epoxy substrate. The applied composition was cured by the application of light or heat to yield an insulating layer. The substrate carrying the insulating layer was immersed in a swelling liquid (Shipley Company) at 50°C for fifteen minutes and in a solution mixture of potassium permanganate and sodium hydroxide at 70°C for five minutes to thereby roughen the surface of the insulating layer, followed by immersing in a neutralization solution (Shipley Company) and washing with water. Next, a palladium catalyst (Shipley Company) layer was formed onto the substrate carrying the insulating layer with a roughened surface, the surface was activated with an accelerator (Shipley Company), and the substrate was immersed in an electroless plating solution(Shipley Company) for thirty minutes and was then immersed in an electroplating solution (copper sulfate) for two hours while passing a current at 1 A/dm to yield a copper-plated layer 25 μm thick. Thus, a substrate was obtained. The bond strength between the insulating layer and the copper-plated layer was measured according to Japanese Industrial Standards (JIS) C6481.

Synthesis Example 1

To a 10-liter reactor equipped with a ten-stage distillation column were charged 6,110 g of 3-cyclohexenylmethyl-3-cyclohexenecarboxylate and 400 g of 1,4-cyclohexanedimethanol as starting materials, followed by dissolution at 90°C. After checking the dissolution, tin chloride was added in an amount of 10 ppm to the starting materials, and the pressure was reduced to 8 Torr at 170°C. A reaction was conducted while distilling off by-produced 3-cyclohexenylmethanol, the heating was terminated at the time when the distillation of 3-cyclohexenylmethanol substantially completed to thereby terminate transesterification. The crude reaction mixture after the completion of transesterification was transparent.

The crude reaction mixture was then washed with 0.5-fold by weight of ion exchanged water at 60°C for one hour and left stand for thirty minutes. After separating the aqueous layer, 3-cyclohexenylmethyl-3-cyclohexenecarboxylate and 3-cyclohexenylmethanol remained in the washings was distilled off in a thin-film evaporator at a jacket temperature of 178°C and a pressure of 3.2 Torr to thereby yield 821 g of an alicyclic olefinic polyester compound. This compound (200 g) and ethyl acetate (200 g) were charged, and 401 g of substantially anhydrous peracetic acid (peracetic acid concentration of 29.5%, water content of 0.35%) was added dropwise at a temperature of the reaction system of 30°C over about two hours while blowing nitrogen gas into the gaseous phase. After the completion of addition of peracetic acid, the reaction mixture was aged at 40°C for three hours, and the reaction was terminated. The resulting reaction mixture was washed with water at 40°C, from which low-boiling components were removed at 70°C and 10 mmHg, to thereby yield 209.4 g of a cycloaliphatic epoxy compound. The cycloaliphatic epoxy compound was white crystals with an oxirane oxygen level of 7.92%. An analysis by $^1H$ NMR revealed that a peak at $\delta$ of about 5.0 to about 5.8 ppm derived from double bond substantially disappears and a proton peak at $\delta$ of about 2.9 to about 3.11 ppm derived from epoxy group forms, showing that this compound is a cycloaliphatic epoxy compound of Formula (1).

Example 1

A photo-curable resin composition was prepared by admixing and stirring 100 parts by weight of the cycloaliphatic epoxy compound obtained in Synthesis Example 1 and 3 parts by weight of the photo-induced cationic polymerization initiator UVACURE 1591 (Daicel Cytec Co., Ltd.) at a constant temperature of 40°C for twenty minutes. The resulting composition was applied to a base material covered with a mould releasing film to a thickness of about 30 $\mu$m using a coater and cured by applying light at 250 mJ/cm$^2$ using a high-pressure mercury lamp and further heating at 150°C for one hour. The cured product was peeled off from the mould releasing film, and the glass transition temperature Tg (DSC method) and shrinkage percentage on curing of the cured product were measured. The resulting composition was also applied to a degreased, copper-clad glass epoxy substrate to a thickness of about 30 $\mu$m using a coater and cured by applying light at 250 mJ/cm$^2$ using a high-pressure mercury lamp and further heating at 150°C for one hour. Copper was then plated, and the bond strength between the cured insulating layer and the copper-plated layer was determined.

Example 2

A thermosetting resin composition was prepared by admixing and stirring 100 parts by weight of the cycloaliphatic epoxy compound obtained in Synthesis Example 1 and 0.6 part by weight of the heat-induced cationic polymerization initiator SI-100L (Sanshin Chemical Industry Co., Ltd.) at a constant temperature of 30°C for twenty minutes. The resulting composition was applied to a base material covered with a mould releasing film to a thickness of about 30 $\mu$m using a coater and cured by heating at 65°C for two hours and at 150°C for further one hour. The cured product was peeled off from the mould releasing film, and the glass transition temperature Tg and shrinkage percentage on curing of the cured product were measured. The resulting composition was also applied to a degreased, copper-clad glass epoxy substrate to a thickness of about 30 $\mu$m using a coater and cured by heating at 65°C for two hours and at 150°C for further one hour. Copper was then plated, and the bond strength between the cured insulating layer and the copper-plated layer was determined.

Example 3

A thermosetting resin composition was prepared by admixing and stirring 100 parts by weight of the cycloaliphatic epoxy compound obtained in Synthesis Example 1, 83 parts by weight of an acid anhydride MH-700 (New Japan Chemical Co., Ltd.), 1 part by weight of ethylene glycol, 0.5 part by weight of triphenylphosphine at a constant temperature of 40°C for twenty minutes. The resulting composition was applied to a base material covered with a mould releasing film to a thickness of about 30 $\mu$m using a coater and cured by heating at 110°C for two hours and at 180°C for further two hours. The cured product was peeled off from the mould releasing film, and the glass transition temperature Tg and shrinkage percentage on curing of the cured product were measured. The resulting composition was also applied to a degreased, copper-clad glass epoxy substrate to a thickness of about 30 $\mu$m using a coater and cured by heating at 110°C for two hours and at 180°C for further two hours. Copper was then plated, and the bond strength between the cured insulating layer and the copper-plated layer was determined.

Comparative Example 1

A photo-curable resin composition was prepared by admixing and stirring 100 parts by weight of a cycloaliphatic epoxy CEL 2021 P (3,4-epoxycyclohexylmethyl 3,4-epoxycyclohexanecarboxylate) (Daicel Chemical Industries, Ltd.) and 3 parts by weight of a photo-induced cationic polymerization initiator UVACURE 1591 (Daicel Cytec Co., Ltd.) at a constant temperature of 40°C for twenty minutes. The resulting composition was applied to a base material covered with a mould releasing film to a thickness of about 30 $\mu$m using a coater and cured by applying light at 250 mJ/cm$^2$ using a high-pressure mercury lamp and further heating at 150°C for one hour. The cured product was peeled off from the mould releasing film, and the glass transition temperature Tg and shrinkage percentage on curing of the cured product were measured. The resulting composition was also applied to a degreased, copper-clad glass epoxy substrate to a

thickness of about 30 μm using a coater and cured by applying light at 250 mJ/cm$^2$ using a high-pressure mercury lamp and further heating at 150°C for one hour. Copper was then plated, and the bond strength between the cured insulating layer and the copper-plated layer was determined.

Comparative Example 2

A thermosetting resin composition was prepared by admixing and stirring 100 parts by weight of a cycloaliphatic epoxy CEL 2021 P (Daicel Chemical Industries, Ltd.) and 0.6 part by weight of a heat-induced cationic polymerization initiator SI-100L (Sanshin Chemical Industry Co., Ltd.) at a constant temperature of 30°C for twenty minutes. The resulting composition was applied to a base material covered with a mould releasing film to a thickness of about 30 μm using a coater and cured by heating at 65°C for two hours and at 150°C for further one hour. The cured product was peeled off from the mould releasing film, and the glass transition temperature Tg and shrinkage percentage on curing of the cured product were measured. The resulting composition was also applied to a degreased, copper-clad glass epoxy substrate to a thickness of about 30 μm using a coater and cured by heating at 65°C for two hours and then at 150°C for further one hour. Copper was then plated, and the bond strength between the cured insulating layer and the copper-plated layer was determined.

Comparative Example 3

A thermosetting resin composition was prepared by admixing and stirring 100 parts by weight of a cycloaliphatic epoxy CEL 2021 P (Daicel Chemical Industries, Ltd.), 128 parts by weight of an acid anhydride MH-700 (New Japan Chemical Co., Ltd.), 1 part by weight of ethylene glycol, and 0.5 part by weight of triphenylphosphine at a constant temperature of 40°C for twenty minutes. The resulting composition was applied to a base material covered with a mould releasing film to a thickness of about 30 μm using a coater and cured by heating at 110°C for two hours and at 180°C for further two hours. The cured product was peeled off from the mould releasing film, and the glass transition temperature Tg and shrinkage percentage on curing of the cured product were measured. The resulting composition was also applied to a degreased, copper-clad glass epoxy substrate to a thickness of about 30 μm using a coater and cured by heating at 110°C for two hours and at 180°C for further two hours. Copper was then plated, and the bond strength between the cured insulating layer and the copper-plated layer was determined.

Comparative Example 4

A photo-curable resin composition was prepared by admixing and stirring 100 parts by weight of a cycloaliphatic epoxy CEL 2021 P (Daicel Chemical Industries, Ltd.), 20 parts by weight of EVCH (diepoxide of vinylcyclohexene) prepared as an epoxidized product of vinylcyclohexene with peracetic acid by the procedure of Synthesis Example 1, and 3 parts by weight of a photo-induced cationic polymerization initiator UVACURE 1591 (Daicel Cytec Co., Ltd.) at a constant temperature of 40°C for twenty minutes. The resulting composition was applied to a base material covered with a mould releasing film to a thickness of about 30 μm using a coater and cured by applying light at 250 mJ/cm$^2$ using a high-pressure mercury lamp and further heating at 150°C for one hour. The cured product was peeled off from the mould releasing film, and the glass transition temperature Tg and shrinkage percentage on curing of the cured product were measured. The resulting composition was also applied to a degreased, copper-clad glass epoxy substrate to a thickness of about 30 μm using a coater and cured by applying light at 250 mJ/cm$^2$ using a high-pressure mercury lamp and further heating at 150°C for one hour. Copper was then plated, and the bond strength between the cured insulating layer and the copper-plated layer was determined.

Comparative Example 5

A photo-curable resin composition was prepared by admixing and stirring 100 parts by weight of a cycloaliphatic epoxy CEL 2021 P (Daicel Chemical Industries, Ltd.), 20 parts by weight of EVCH (diepoxide of vinylcyclohexene) prepared as an epoxidized product of vinylcyclohexene with peracetic acid by the procedure of Synthesis Example 1, 20 parts by weight of Denarex R-45 EPT (polybutadiene diglycidyl ether) (Nagase Chemtex Corporation), and 3 parts by weight of a photo-induced cationic polymerization initiator UVACURE 1591 (Daicel Cytec Co., Ltd.) at a constant temperature of 40°C for twenty minutes. The resulting composition was applied to a base material covered with a mould releasing film to a thickness of about 30 μm using a coater and cured by applying light at 250 mJ/cm$^2$ using a high-pressure mercury lamp and further heating at 150°C for one hour. The cured product was peeled off from the mould releasing film, and the glass transition temperature Tg and shrinkage percentage on curing of the cured product were measured. The resulting composition was also applied to a degreased, copper-clad glass epoxy substrate to a thickness of about 30 μm using a coater and cured by applying light at 250 mJ/cm$^2$ using a high-pressure mercury lamp and further

heating at 150°C for one hour. Copper was then plated, and the bond strength between the cured insulating layer and the copper-plated layer was determined.
The compositions of the resin compositions and the physical properties of the resulting cured products according to Examples and Comparative Examples are shown in Table 1.

[Table 1]

Table 1

| | Example 1 | Example 2 | Example 3 | Com. Ex. 1 | Com. Ex. 2 | Com. Ex. 3 | Com. Ex. 4 | Com. Ex. 5 |
|---|---|---|---|---|---|---|---|---|
| Cycloaliphatic epoxy compound | Synthesis Example 1 | Synthesis Example 1 | Synthesis Example 1 | CEL 2021 P | CEL 2021 P | CEL 2021 P | CEL 2021 P | CEL 2021 P |
| (part by weight) | 100 | 100 | 100 | 100 | 100 | 100 | 100 | 100 |
| Other epoxy compound (1) (part by weight) | - | - | - | - | - | - | EVCH 20 | EVCH 20 |
| Other epoxy compound (2) (part by weight) | - | - | - | - | - | - | - | R-45 EPT 20 |
| Photo-induced cationic | UVACURE1591 | - | - | UVACURE1591 | - | - | UVACURE1591 | UVACURE1591 |
| polymerization initiator (part by weight) | 3 | - | - | 3 | - | - | 3 | 3 |
| Heat-induced cationic | - | SI-100L | - | - | SI-100L | - | - | - |
| polymerization initiator (part by weight) | - | 0.6 | - | - | 0.6 | - | - | - |
| Curing agent (part by weight) | - | - | MH-700 83 | - | - | MH-700 128 | - | - |
| EG (part by weight) | - | - | 1 | - | - | 1 | - | - |
| TPP (part by weight) | - | - | 0.5 | - | - | 0.5 | - | - |
| Curing condition | irradiation at 250 mJ/$cm^2$ and heating at 150°C for 1 hr | heating at 65°C for 2 hr and at 150°C for 1 hr | heating at 110°C for 2 hr and at 180°C for 2 hr | irradiation at 250 mJ/$cm^2$ and heating at 150°C for 1 hr | heating at 65°C for 2 hr and at 150°C for 1 hr | heating at 110°C for 2 hr and at 180°C for 2 hr | irradiation at 250 mJ/$cm^2$ and heating at 150°C for 1 hr | irradiation at 250 mJ/$cm^2$ and heating at 150°C for 1 hr |
| Glass transition temperature Tg (DSC) (°C) | 165 | 168 | 170 | 175 | 175 | 198 | 174 | 160 |

(continued)

| Curing condition | irradiation at 250 mJ/cm$^2$ and heating at 150°C for 1 hr | heating at 65°C for 2 hr and at 150°C for 1 hr | heating at 110°C for 2 hr and at 180°C for 2 hr | irradiation at 250 mJ/cm$^2$ and heating at 150°C for 1 hr | heating at 65°C for 2 hr and at 150°C for 1 hr | heating at 110°C for 2 hr and at 180°C for 2 hr | irradiation at 250 mJ/cm$^2$ and heating at 150°C for 1 hr | irradiation at 250 mJ/cm$^2$ and heating at 150°C for 1 hr |
|---|---|---|---|---|---|---|---|---|
| Shrinkage percentage on curing (%) | 2.5 | 2.2 | 1.7 | 4.5 | 4.7 | 3.4 | 3.8 | 5.1 |
| Bond strength with metal plated layer (kg/cm) | 0.9 | 0.9 | 1.0 | 0.4 | 0.4 | 0.5 | 0.4 | 0.8 |

The symbols in Table 1 are as follows.
CEL 2021 P: Cycloaliphatic epoxy compound [Daicel Chemical Industries, Ltd.]
EVCH: Diepoxide of vinylcyclohexene
R-45 EPT: Polybutadiene diglycidyl ether [Nagase Chemtex Corporation]
UVACURE 1591: Photo-induced cationic polymerization initiator [Daicel Cytec Co., Ltd.]
SI-100L: Heat-induced cationic polymerization initiator [Sanshin Chemical Industry Co., Ltd.]
MH-700: Methylhexahydrophthalic anhydride [New Japan Chemical Co., Ltd.]
EG: Ethylene glycol
TPP: Triphenylphosphine

Table 1 demonstrates that the curable resin compositions according to the present invention yield cured products as interlayer dielectric films that show less shrinkage on curing and are excellent in heat resistance, flexibility, and adhesion with plated metal layers.

Industrial Applicability

The curable resin compositions according to the present invention yield interlayer dielectric films that show less shrinkage on curing and are excellent in heat resistance, flexibility, and adhesion with plated metal layers. Interlayer dielectric films can be used typically in LSIs and multilayer printed wiring boards.

## Claims

1. A curable resin composition comprising:

   at least one cycloaliphatic epoxy compound represented by following Formula (1):

   [Chemical Formula 1]

   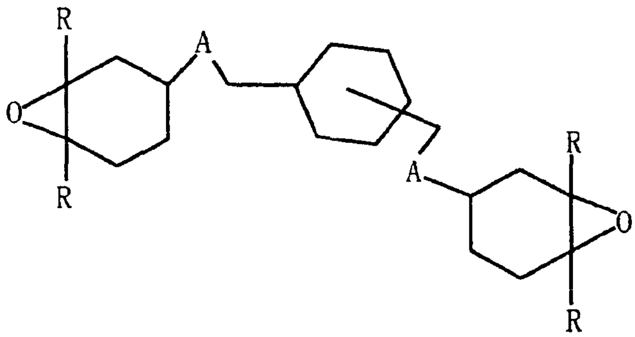

   (1)

   wherein R represents hydrogen atom or a hydrocarbon group having one to five carbon atoms; and A represents a group selected from the group consisting of ether group, thioether group, sulfonyl group, carbonyl group, carbonate group, ester group, and acetal group; and
   at least one of a cationic polymerization initiator or a curing agent.

2. The curable resin composition of Claim 1, wherein the cationic polymerization initiator is a heat-induced cationic polymerization initiator.

3. The curable resin composition of Claim 1, wherein the cationic polymerization initiator is a photo-induced cationic polymerization initiator.

4. The curable resin composition of Claim 1, wherein the curing agent is a polybasic acid anhydride.

5. The curable resin composition of any one of Claims 1 to 4, wherein the polar group A is an ester group.

**6.** An interlayer dielectric film as a cured product of the curable resin composition of any one of Claims 1 to 5.

**INTERNATIONAL SEARCH REPORT**

International application No. PCT/JP2006/300333

A. CLASSIFICATION OF SUBJECT MATTER

***C08G59/24***(2006.01), ***H01L21/312***(2006.01), ***H05K3/46***(2006.01)

According to International Patent Classification (IPC) or to both national classification and IPC

B. FIELDS SEARCHED

Minimum documentation searched (classification system followed by classification symbols)

C08G59/00-59/72

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

CA(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| A | JP 5-170753 A (Union Carbide Chemicals and Plastics Co., Inc.), 09 July, 1993 (09.07.93), Claims & EP 0479166 A1 | 1-6 |
| P,X | JP 2005-330335 A (Nitto Denko Corp.), 02 December, 2005 (02.12.05), Claims; Par. No. [0019] (Family: none) | 1,4,5 |
| P,X | WO 2005/044890 A1 (UNION CARBIDE CHEMICALS & PLASTICS TECHNOLOGY CORP.), 19 May, 2005 (19.05.05), Claims; pages 6, 8 (Family: none) | 1-3,5 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 February, 2006 (22.02.06) | 07 March, 2006 (07.03.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 1278561 A
- JP 6085091 A
- JP 5170753 A
- JP 2004236505 A